# EUROPÄISCHE PATENTSCHRIFT

(11) **EP 1 554 747 B1**
(45) Veröffentlichungstag und Bekanntmachung des Hinweises auf die Patenterteilung: **30.08.2006**
(21) Anmeldenummer: 03753277.7
(22) Anmeldetag: 09.09.2003
(51) Int. Cl.: H01L 21/00, H01L 21/306

(54) **Plasmaanlage und Verfahren zum anisotropen Einätzen von Strukturen in ein Substrat**
Plasma system and method for anisotropically etching structures into a substrate
Installation au plasma et procédé de gravure anisotrope de structures dans un substrat

(30) Priorität: 14.10.2002 DE 10247913
(43) Veröffentlichungstag der Anmeldung: 20.07.2005
(73) Patentinhaber: ROBERT BOSCH GMBH, 70442 Stuttgart (DE)
(72) Erfinder: LAERMER, Franz, 71263 Weil der Stadt (DE); URBAN, Andrea, 70563 Stuttgart (DE)
(86) Internationale Anmeldenummer: PCT/DE2003/002971
(87) Internationale Veröffentlichungsnummer: WO 2004/036627

(56) Entgegenhaltungen:
- EP-A- 0 849 766
- WO-A-00/79579
- DE-A- 10 051 831
- DE-A- 19 933 841
- DE-C- 4 241 045
- US-A1- 2002 144 974
- US-B1- 6 431 113

## Beschreibung

Die Erfindung betrifft eine Plasmaanlage und ein Verfahren zum anisotropen Einätzen von Strukturen, insbesondere von mit einer Ätzmaske definierten Strukturen in ein Siliziumsubstrat, mittels eines Plasmas, nach der Gattung der unabhängigen Ansprüche.

### Stand der Technik

Aus DE 42 41 045 C1 ist ein Verfahren zum Hochraten-Plasmaätzen von Silizium bekannt, wobei abwechselnd geätzt und auf den Seitenwänden geätzter Strukturen ein teflonartiges Polymer abgeschieden wird, welches diese bei den darauf folgenden Ätzschritten vor einem Ätzangriff schützt. Als Ätzgase werden im Plasma Fluorradikale liefernde Gase wie SF₆, NF₃ oder ClF₃ eingesetzt. Als Passiviergase werden im Plasma teflonbildende Monomere liefernde Gase wie C₄F₈ oder C₃F₆ eingesetzt. Dieses Verfahren erlaubt Ätzraten von bis zu 20 µm/min bei exzellenter Strukturgenauigkeit und Selektivität auch gegenüber einfachen Maskenmaterialien wie Photolack oder SiO₂.

Bei dem Verfahren gemäß DE 42 41 045 Cl werden vergleichsweise kurze Depositionsschritte bzw. Passiviergasschritte und länger andauernde Ätzschritte eingesetzt, um eine möglichst hohe Ätzrate zu erzielen. Meist werden in Verbindung mit induktiv gekoppelten Plasmaquellen Rezepte eingesetzt, bei denen Passiviergasschritte von jeweils 3 bis 5 Sekunden und Ätzschritte von jeweils 10 bis 12 Sekunden Dauer einander abwechseln. Bei kürzeren Passiviergasschritten wird es zunehmend schwieriger, diese mit der erforderlichen Genauigkeit über sehr viele Zyklen zu reproduzieren.

US-B1-6431113 beschreibt eine Plasmaanlage und ein verfahren zum Ernätzen von Strukturen.

Aufgabe der vorliegenden Erfindung war die Bereitstellung einer Plasmaanlage und eines Verfahrens mit der bzw. dem eine gegenüber dem Stand der Technik höhere Ätzrate bei der anisotropen Ätzung von insbesondere Silizium als Substrat bei gleichzeitig weiterhin hoher Profilkontrolle und insbesondere auch weiterhin hoher Maskenselektivität erreicht werden kann.

### Vorteile der Erfindung

Erfindungemäss wird disc Aufgabe durch die Merkmale der unabhängigen Ansprüche 1 und 9 gelöst. Das erfindungsgemäße Verfahren und die erfindungsgemäße Plasmaanlage haben gegenüber dem Stand der Technik den Vorteil einer höheren Ätzrate vor allem bei der anisotropen Ätzung von insbesondere Silizium als Substrat bei gleichzeitig hoher Profilkontrolle und insbesondere auch weiterhin hoher Maskenselektivität.

Insbesondere ist vorteilhaft, dass die erreichbare Ätzrate und die Strukturgenauigkeit mit kürzerer Taktzeit der Passiviergastakte immer besser wird, so dass man sich bei den erfmdungsgemäß eingesetzten, sehr kurzen Passiviergastakten an einen "optimalen" Prozess annähert, bei dem überhaupt keine Unterbrechungen durch einen Passiviergaseinsatz bzw. überhaupt keine Passivierschritte mehr erforderlich sind, sondern der ununterbrochen ätzt. Andererseits würde ein solcher "optimaler" Prozess zu einer unerwünschten isotropen statt anisotropen Ätzung führen, während der erfindungsgemäße Prozess trotz der kurzen Passiviergastakte weiterhin ein anisotropes Einätzen von Strukturen ermöglicht.

Die erfindungsgemäße Plasmaanlage und das erfindungsgemäße Verfahren erlaubt daher eine weitgehende Annäherung an einen "optimalen Prozess" unter Beibehaltung der Anisotropie der Ätzung und einer hohen Profilkontrolle und Maskenselektivität.

Bei der erfindungsgemäßen Plasmaanlage ist weiter vorteilhaft, dass sie auf einer üblichen Plasmaanlage, beispielsweise mit einer induktiv gekoppelte Plasmaquelle, aufbauen kann, so dass keine wesentlichen Anlageninvestitionen erforderlich sind bzw. bestehende Plasmaanlagen ohne größeren Aufwand entsprechend nachgerüstet werden können.

Vorteilhafte Weiterbildungen der Erfindung ergeben sich aus den in den Unteransprüchen genannten Maßnahmen.

So ist besonders vorteilhaft, dass das erfindungsgemäße Verfahren ohne Weiteres durch Modifikation des Verfahrens zur anisotropen Ätzung von Silizium nach der Art der DE 42 41 045 C1 realisiert oder in dieses integriert werden kann, wobei auch dort ein nahezu unterbrechungsfreies Plasmaätzen erreichbar ist, das sich durch besonders hohe Ätzraten bei besonders guter Strukturtreue und minimalen Hinterschneidungen oder Wandrauhigkeiten auszeichnet.

Weiter ist vorteilhaft, wenn bei dem Verfahren auf der Grundlage des Verfahrens gemäß DE 42 41 045 Cl als Passiviergas ein möglichst stark passivierendes, teflonbildende Monomere lieferndes Passiviergas eingesetzt wird. Neben C₄F₈ oder C₃F₆ eignen sich dazu vor allem Fluorkohlenwasserstoffe mit noch niedrigerem Fluor-zu-Kohlenstoff-Verhältnis wie C₄F₆ (Hexafluor-1,3-butadien) oder C₅F₈ (Octafluor-1,3-pentadien) sowie, weniger bevorzugt, auch C₂H₂F₂ (Difluoroethylen). Besonders vorteilhaft ist das besonders effizient Polymere bildende C₄F₆. Diese Gase können bei gegenüber C₄F₈ oder C₃F₆ bevorzugt reduziertem Gasfluss bzw. reduzierter Stoffmenge während der Passivierschritte aus dem Puffertank entnommen werden.

Bei den Passiviergasen C₄F₆ und C₅F₈ erfolgt neben den weiterhin einsetzbaren Gasen C₄F₈ oder C₃F₆ insgesamt vorteilhaft eine schnellere Polymerabscheidung aus dem Plasma bei ansonsten vergleichbaren Plasmakenndaten, wobei das deponierte Polymer zudem dichter und dank des niedrigen Fluor-zu-Kohlenstoff-Verhältnisses dieser Gase auch deutlich stärker quervernetzt ist. Zudem ist es durch einen höheren Kohlenstoffgehalt widerstandsfähiger gegenüber einem Ätzabtrag.

Da bei der anisotropen Ätzung von Silizium beispielsweise nach der Art der DE 42 41 045 C1 die Effizienz des Aufbaus eines Seitenwandpolymerfilms als Schutzfilm und dessen Beständigkeit im nachfolgenden Ätzschritt neben der im Ätzschritt verfügbaren Fluorradikalenkonzentration eine entscheidende Rolle für die Prozessperformance spielt, ergeben sich daraus unmittelbar erhebliche Verbesserungspotenziale.

Insbesondere erlauben die verbesserten Eigenschaften des in den Passivierschritten als Seitenwandfilm deponierten Polymers hinsichtlich Dichtheit, Quervemetzung, eines höheren Kohlenstoffgehaltes und einer erhöhten Widerstandsfähigkeit gegen einen Ätzabtrag bei einem Prozess gemäß DE 42 41 045 Cl erheblich kürzere Passiviergastaktzeiten von deutlich unter 1 s, z.B. von 100 ms bis 500 ms, und weiterhin auch vergleichsweise deutlich verlängerte Ätzgastaktzeiten von ca. 1 s bis hin zu 20 s bis 30 s, d.h. das Verhältnis von Ätzzeit zu Passivierzeit verschiebt sich deutlich zugunsten der Ätzzeit auf Werte von nunmehr 10:1 bis 30:1 oder sogar mehr. Das höhere zeitliche Gewicht der Ätzschritte an der Gesamtprozesszeit führt unmittelbar zu entsprechend höheren Ätzraten.

Ein weiterer Mechanismus in Richtung höherer Ätzraten resultiert aus dem erläutert grö-βeren Kohlenstoffgehalt der Seitenwandpolymerfilme, deren stärkerer Quervernetzung und damit deren höherer Beständigkeit gegenüber einem Abtrag.

Da durch die sehr kurzen Passiviergastaktzeiten und die bevorzugt eingesetzten Passiviergase C₄F₆ oder C₅F₈ oder auch C₂F₂F₂ zunächst insgesamt weniger Seitenwandpolymermaterial im Vergleich zu den Passiviergasen C₄F₈ oder C₃F₆ während der an sich isotropen Ätzschritte wieder abgetragen, vorwärts getrieben und in tiefer liegenden Regionen der erzeugten Strukturen bzw. der Seitenwände der erzeugten Trenchgräben, welche gerade durch den Ätzschritt eröffnet werden, redeponiert wird, andererseits aber dank der höheren Beständigkeit der erzeugten teflonartigen Seitenwandpolymerfilme immer noch eine ausreichende lokale Passivierwirkung und eine damit verbundene lokale Anisotropie des Ätzschrittes erreicht wird, geht letztlich weniger Fluor durch Wechselwirkung mit während der Ätzschritte ionengetrieben transportierten Polymermaterialien bzw. Passiviergasbestandteile verloren. Die erzielte stärkere C-C-Vernetzung hilft dabei ebenfalls, da Fluorradikale weniger innere C-C-Bindungen als freie äußere C-Bindungen angreifen. Auch dies steigert letztlich die Effizienz des Gesamtätzprozesses.

Die Dynamik des Seitenwandpolymers hat bekanntermaßen einen großen Einfluss auf die netto zur Verfügung stehende Menge an freien Fluorradikalen. Eine höhere, gegenüber Silizium wirksame Fluorradikalenkonzentration zusammen mit größeren zulässigen Ätzzyklusdauem bzw. Ätzgastaktzeiten relativ zu den Passivierzyklusdauern bzw. den Passiviergastaktzeiten steigert somit die erzielbaren Ätzraten erheblich.

Die Maskenselektivität wird schließlich vorteilhaft dadurch verbessert, dass die auf der eingesetzten Maske abgeschiedenen Passivierschichten durch die erläuterten Mechanismen nun ebenfalls beständiger sind als nach dem Stand der Technik, und somit während des Ätzprozesses die Substratmaskierung, d.h. bevorzugt die Maskierung eines Siliziumwafers, insbesondere im Falle einer Photolackmaskierung besonders wirksam passiviert wird.

### Zeichnungen

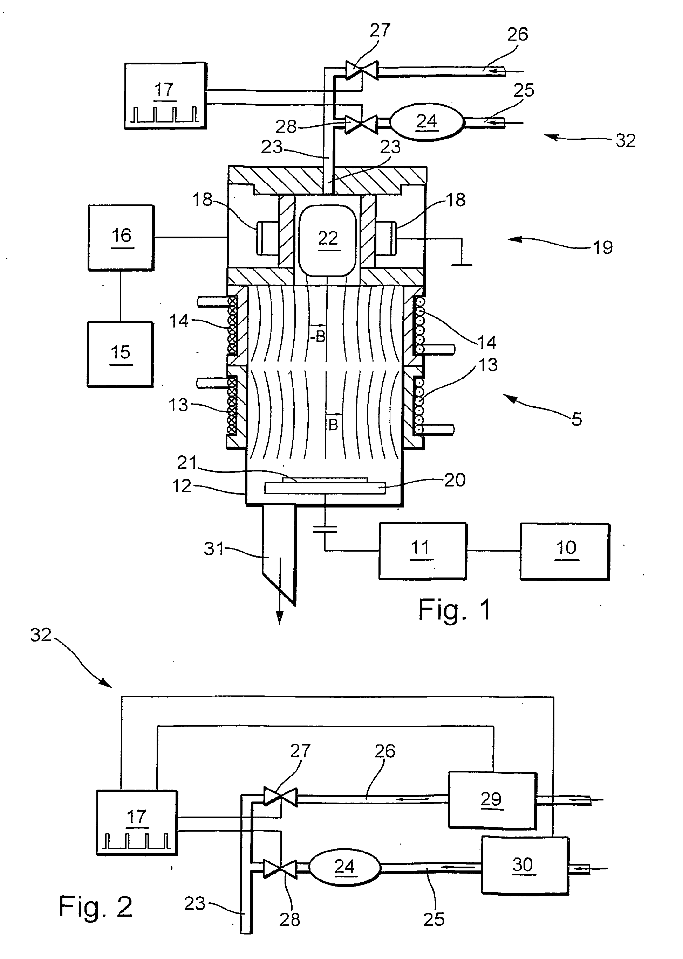

Die Erfindung wird anhand der Zeichnungen und in der nachfolgenden Beschreibung näher erläutert. Es zeigt Figur 1 eine Prinzipskizze einer Plasmaanlage im Rahmen eines ersten Ausführungsbeispiels, und Figur 2 einen Ausschnitt aus Figur 1 mit einer modifizierten Gaszufuhrsteuerung im Rahmen eines zweiten Ausführungsbeispiels.

### Ausführungsbeispiele

Die Figur 1 zeigt eine Plasmaanlage 5 mit einer Ätzkammer 12 und einer Plasmaquelle 19, wie sie aus DE 100 51 831 A1 weitgehend bekannt ist. Insbesondere befindet sich unterhalb der Plasmaquelle 19 ein Ionendiskriminators mit zwei bei Betrieb paarweise gegensinnig von einem Strom durchflossenen Spulen, einer oberen Spule 14 und einer unteren Spule 13, sowie mit einer Driftzone, die beispielsweise durch einen "Spacer" oder einen Distanzring bereitgestellt wird, für eine Ausbreitung eines im Bereich der Plasmaquelle 19 in der Ätzkammer 12 erzeugten Plasmas 22 in Richtung auf ein Substrat 21, beispielsweise einen Siliziumwafer, der sich bevorzugt auf einer Substratelektrode 20 befindet. Die Substratelektrode 20 ist weiter über eine erste Impedanzanpasseinrichtung 11 (erste "Matchbox") mit einem Substratbiasgenerator 10 verbunden. Die Plasmaquelle 19 ist bevorzugt eine induktiv gekoppelte Plasmaquelle mit einer Spule 18, die über eine zweite Impedanzanpasseinrichtung (zweite "Matchbox") mit einem Spulengenerator 15 in Verbindung steht. Schließlich weist die Ätzkammer eine leistungsfähige, in Figur 1 lediglich angedeutete Pumpeinrichtung 31 auf, mit der die Ätzkammer 12 evakuierbar.ist. Zu weiteren Einzelheiten zum Aufbau und zum Betrieb der Plasmaanlage 5 sei zunächst aufDE 100 51 831 A1 verwiesen.

Im Unterschied zu der Plasmaanlage gemäß DE 100 51 831 A1 weist die erfindungsgemäße Plasmaanlage 5 eine modifizierte Gasversorgungseinrichtung 32 der Ätzkammer 12 auf. Dazu ist eine möglichst kurze, vorzugsweise nicht mehr als 20 cm lange Zufuhrleitung 23 vorgesehen, die in die Ätzkammer 12 mündet, und die mit einer Ätzgasleitung 26 und einer davon getrennten bzw. unabhängigen Passiviergasleitung 25 verbunden ist. Weiter ist vor der Einmündung der Ätzgasleitung 26 in die Zufuhrleitung 23 ein Ätzgasventil 27 und vor der Einmündung der Passiviergasleitung 25 in die Zufuhrleitung 23 ein Passiviergasventil 28 vorgesehen. Schließlich ist in die Passiviergasleitung 25 vor dem Passiviergasventil 28 ein Puffertank 24 zwischengeschaltet. Im Übrigen kann auch in der Ätzgasleitung 26 vor dem Ätzgasventil 27 ein in Figur 1 nicht dargestellter Puffertank vorgesehen sein, der den Ätzgaszufluss während der Passiviergastakte, d.h. bei geschlossenem Ätzgasventil 27, puffert.

Bevorzugt sind die Ventile 27, 28 möglichst nahe an der Ätzkammer 12 angeordnet, d. h. die den nachfolgenden Ventilen 27, 28 nachfolgenden Gasleitungen sind möglichst kurz. Weiter sollte auch der Puffertank 24 unmittelbar vor dem Passiviergasventil 28 angeordnet sein. Im Übrigen kann auf die Zufuhrleitung 23 auch ganz verzichtet, wenn die Ätzgasleitung 26 und die Passiviergasleitung 25 unmittelbar über zwei zugeordnete Eintrittsöffnungen in die Ätzkammer 12 münden. In diesem Fall befinden sich die Ventile 27, 28 bevorzugt jeweils unmittelbar vor diesen Eintrittsöffnungen auf der Ätzkammer 12.

In Figur 1 ist schließlich eine bevorzugt programmierbare Steuereinheit 17 vorgesehen, mit der die Ventile 27, 28 betätigbar sind. Daneben sind zwei in Figur 1 nicht dargestellte Massenflussregler vorgesehen, die vor den Ventilen 27 bzw. 28 angeordnet und der Ätzgasleitung 26 bzw. der Passiviergasleitung 25 zugeordnet bzw. in diese integriert sind. Die Steuereinheit 17 ist bevorzugt auch mit diesen Massenflussreglern verbunden, wie dies in Figur 2 im Rahmen eines zweiten Ausführungsbeispiels erläutert wird. Dort ist der Ätzgasleitung 26 ein erster Massenflussregler 29 und der Passiviergasleitung 27 ein zweiter Massenflussregler 30 zugeordnet, die bevorzugt erneut möglichst nahe an der Ätzkammer 12 angeordnet sind. Alternativ ist es auch möglich, die Massenflussregler 29, 30 entfernt von der Ätzkammer 12 beispielsweise in einer sogenannten "Gasbox" zu platzieren.

Die Steuereinheit 17 ist bevorzugt in die Prozessablaufsteuerung der Plasmaanlage 5 als Hardwarekomponente integriert oder stellt einen Teil der Prozessablaufsteuerung, d.h. insbesondere des Software-Codes, dar.

Der Puffertank 24 weist bevorzugt ein Volumen von 0,1 Liter bis 1 Liter, beispielsweise 0,5 Liter, auf, und ist besonders bevorzugt aus Edelstahl mit elektropolierten Innenwänden ausgeführt. Falls vor dem Ätzgasventil 27 in der Ätzgasleitung 26 ebenfalls ein Puffertank vorgesehen ist, ist dieser bevorzugt analog ausgeführt.

Das Ätzgasventil 27 ist bei Betrieb der Plasmaanlage 5 als "normally open"-Ventil ausgelegt, während das Passiviergasventil 28 als "normally closed"-Ventil ausgelegt ist. Die Ventile 27, 28 münden, wie erläutert, möglichst unmittelbar in die Ätzkammer 12, wobei für die Ausgänge des Ätzgasventils 27 und des Passiviergasventils 28 entweder eigene kurze Gasleitungen mit möglichst hohem Querschnitt und einer Länge von maximal 20 cm vorgesehen sind, oder die gemeinsame kurze Zufuhrleitung 23 mit ebenfalls möglichst hohem Querschnitt. Auch die Verbindung von Puffertank 24 zu dem Passiviergasventil 28 sollte eine Länge von weniger als 20 cm aufweisen und mit möglichst hohem Querschnitt ausgeführt sein. Im Übrigen ist es möglich und meist auch vorteilhaft, das Ätzgasventil 27 und das Passiviergasventil 28 in einem einzigen Umschaltventil zusammenzufassen, das im Ruhezustand die Ätzgasleitung 27 und im aktivierten Zustand die Passiviergasleitung 25 zur Ätzkammer 12 durchschaltet. Dies führt in einfacher Weise zu einer perfekten Synchronisation der Öffnungs- und Schließoperationen für die Leitungen 25,27.

Mit der Plasmaanlage 5 wird ein anisotropes Einätzen von mit Hilfe einer Ätzmaske lateral exakt definierten Strukturen in Silizium, d.h. das Substrat 21, gemäß DE 41 42 045 C1 vorgenommen, wobei als Passiviergas bevorzugt C₄F₆ eingesetzt wird. Dazu werden die Ventile 27, 28 abwechselnd geöffnet und geschlossen. Bevorzugt ist das Passiviergasventil 28 und besonders bevorzugt auch das Ätzgasventil 29 ein schnell schaltendes, beispielsweise elektromagnetisches Ventil, das beispielsweise direkt mit einem 24 V-Signal angesteuert werden kann, und das Schaltzeiten im Bereich von einigen 10 Millisekunden aufweist. Liegen dabei 24 V an, schließt das Ätzgasventil 28 und sperrt das in der Ätzgasleitung 26 geführte Ätzgas von der Ätzkammer 12 ab, während das Passiviergasventil 28 öffnet und das in der Passiviergasleitung 25 geführte Passiviergas zur Ätzkammer 12 frei gibt. Entsprechend schaltet ein Umschaltventil bei angelegter 24 V-Spannung die Ätzkammer um von Ätzgas auf Passiviergas, d.h. auf den Puffertank 24. Alternativ sind für die Ventile 27, 28 auch pneumatische Ventile mit elektrischen Vorsteuerventilen denkbar, wobei jedoch ein langsameres Ansprechen in Kauf genommen werden muss.

Bei Betrieb der Plasmaanlage 5 im Rahmen eines Ätzverfahrens gemäß DE 42 41 045 C 1 wird beispielsweise ein Ätzgasfluss von 300 bis 1000 sccm SF₆, vorzugsweise 500 sccm SF₆, und ein Passiviergasfluss von 10 bis 500 sccm C₄F₆, vorzugsweise 50 sccm bis 200 sccm C₄F₆ (sccm = cm³/min bei Normaldruck) eingesetzt. Die an der induktiven Plasmaquelle 19 eingesetzten Leistungen liegen bei 2000 W bis 5500 Watt.

Die der Ätzgasleitung 26 bzw. der Passiviergasleitung zugeordneten Massenflussregler 29, 30 werden in einer ersten Verfahrensvariante jeweils auf einen festen Gasfluss eingestellt, beispielsweise 500 sccm SF₆ und 100 sccm C₄F₆ Das Ätzgas SF₆ fließt zunächst über das geöffilete Ventil 27 in die Ätzkammer 12, während das Passiviergas C₄F₆ zunächst den Puffertank 24 füllt und durch das geschlossene Ventil 28 am Einströmen in die Ätzkammer 12 gehindert wird. Nach beispielsweise 5 Sekunden wird dann durch die Steuereinheit 17 ein kurzer Impuls auf die beiden Ventile 27, 28 gegeben, so dass sich das Ventil 27 schließt und für einen kurzen Zeitraum von 0,05 s bis 1 s, vorzugsweise von 0,1 s bis 0,5 s, den weiteren Zufluss des Ätzgases in die Ätzkammer 12 sperrt, während sich das Passiviergasventil 28 für diesen Zeitraum öffnet und den Weg des Passiviergases in die Ätzkammer 12 frei gibt, so dass sich der Puffertank 24 nahezu instantan in die Ätzkammer 12 hin entleert. Nach Ablauf der vorgewählten Taktzeit von 0,05 Sekunden bis 1 Sekunde, beispielsweise 0,3 Sekunden, wird dann durch entsprechende elektrische Signale aus der Steuereinheit 17 das Ventil 27 wieder geöffnet und entsprechend Ventil 28 wieder geschlossen, d.h. das Ätzgas strömt wieder in die Ätzkammer 12 und das Passiviergas füllt wieder den Puffertank 24, bis sich nach weiteren 5 Sekunden das erläuterte Schaltspiel wiederholt. Als zeitlicher Abstand zwischen den Passiviergastakten, d.h. als zeitliche Dauer der Ätzgastakte, werden 1 s bis 15 s, vorzugsweise 2 s bis 7 s, eingestellt.

Insgesamt wird auf diese Weise die weitaus überwiegende Zeit geätzt und der Ätzvorgang nur während der sehr kurzen Passiviergastakte unterbrochen und ein Schwall von Passiviergas der Plasmaquelle 19 zugeführt, so dass sich ein "Hauch" von Teflonpassivierung über alle geätzten Strukturen legt und die erforderliche Seitenwandpassivierung auch für den nachfolgenden Ätzschritt bereitstellt.

In der vorstehend erläuterten Verfahrensführung arbeiten die Massenflussregler 29, 30 kontinuierlich. Für den Ätzgasfluss ist die kurzzeitige Unterbrechung des Zugangs zur Ätzkammer 12 dabei ohne Bedeutung bzw. kann bei Bedarf durch den erläuterten zusätzlichen Puffertank für das Ätzgas abgefangen werden. Das Passiviergas fließt von dem zweiten Massenflussregler 30 durchgängig in den Puffertank 24, der sich periodisch während der sehr kurzen Passiviergastakte in die Ätzkammer 12 entleert. Insofern entscheidet, nun die Menge des im Puffertank 24 vor dem Öffnen des Passiviergasventils 28 akkumulierten Passiviergases über die Menge an Seitenwandpassivierung, die in den Ätzprozess eingetragen wird. Bei einem zeitlichen Abstand t₁ zwischen den einzelnen Passiviergastakten, der in der erläuterten Verfahrensführung gleichbedeutend mit der zeitlichen Länge der Ätzzyklen oder der Ätzgastakte ist, ist die in dem Puffertank 24 akkumulierte Stoffmenge des Passiviergases gleich dem Produkt aus Gasfluss und dieser Zeit t₁.

In einer alternativen zweiten Verfahrensführung wird der zweite Massenflussregler 30 über die Steuereinheit 17 gemäß Figur 2 zusätzlich mit der Steuerung der Ventile 27, 28 synchronisiert getaktet. Dadurch wird die Schwierigkeit bzw. der Nachteil umgangen, dass die Stoffmenge des Passiviergases, die während der Passiviergastakte in die Ätzkammer 12 gelangt, direkt mit dem zeitlichen Abstand der Passiviergastakte, der der Ätzschrittdauer entspricht, skaliert, so dass jede Änderung der Ätzschrittdauer bzw. der Ätzgastaktzeit auch zu einer Änderung der akkumulierten Passiviergasmenge in dem Puffertank 24 führt.

Wird beispielsweise der zeitliche Abstand zwischen den Passiviergastakten, also die Ätzschrittdauer halbiert, so wird dementsprechend auch die Zeitdauer, während der der Puffertank 24 mit Passiviergas gefüllt wird, halbiert. Um diese halbe Aufladezeit zu korrigeren, muss dann im Prozessprogramm über die Steuereinheit 17 der von dem zweiten Massenflussregler 30 zu liefernde Passiviergasfluss verdoppelt werden.

Diese zu einer vergleichsweise aufwändigen Prozessanpassung auf den Einzelfall führende Kopplung der Ätzschrittdauer oder Ätzgastaktzeit t₂ und des zeitlichen Abstandes t₁ der einzelnen Passiviergastakte wird nun bevorzugt dadurch vermieden, dass der zweite Massenflussregler 30 über die Steuereinheit 17 lediglich über eine Tankladezeit t_{L} aktiv geschaltet wird, die kürzer ist als die Ätzschrittdauer t₂. Dazu wird nach einem Wiedereinsetzen des Ätzgasflusses in die Ätzkammer 12 der zweite Massenflussregler 30 für eine Zeitspanne t₂-t_{L} ausgeschaltet, d. h. der angeforderte Passiviergasfluss während dieser Zeit auf 0 gesetzt. Erst nach Ablaufen der Wartezeit t₂-t_{L} nach dem Beginn des Ätzschritts wird dann der zweite Massenflussregler 30 wieder bis zum Ende des darauf folgenden Passiviergastaktes bzw. zum Beginn des darauf folgenden Ätzgastaktes auf seinen Sollgasfluss gesetzt. Dabei wird beispielsweise wird t₂=5 Sekunden, t_{L}=2 Sekunden und der zu Passiviergasfluss zu 200 sccm gewählt.

Auch diese Verfahrensführung weist jedoch noch den Nachteil auf, dass während der Passiviergastakte nicht nur der Inhalt des Puffertanks 24 in die Ätzkammer 12 strömt, sondern auch noch eine geringe Passiviergasmenge während des Passiviergastaktes von dem zweiten Massenflussregler 30 nachgeliefert wird. Zwar ist der Passiviergastakt kurz und diese Menge entsprechend klein, es wird damit aber das Ansprechverhalten des Passiviergasventils 28 in den Prozess übertragen.

In dritten Verfahrensvariante wird daher der zweite Massenflussregler 30 von der Steuereinheit 17 so gesteuert, dass der Passiviergasfluss erst nach dem Schließen des Passiviergasventils 28 auf seinen Sollwert hochgeregelt wird und dort über die Tankladezeit t_{L}, die kleiner als die Ätzschrittdauer t₂ oder die Zeit zwischen den Passiviergastakten t₁ ist, dort verbleibt, nach Ablauf von t_{L} aber für die restliche Zeit t₂ oder t₁ auf 0 zurückgeregelt wird. Dabei ist t_{L} stets kleiner t₁ oder t₂. In dem Puffertank 24 verbleibt also die während der Zeitspanne t_{L} eingeströmte Passiviergasmenge so lange eingeschlossen, bis das Passiviergasventil 28 kurz geöffnet wird und die gespeicherte Passiviergasmenge in die Ätzkammer 12 überströmen kann. Während dieser Zeit ist weiter der zweite Massenflussregler 30 noch auf 0 geregelt und kann somit kein Passiviergas nachliefern. Die zugeführte Stoffmenge an Passiviergas ist bei dieser Verfahrensführung besonders präzise einstellbar und unabhängig vom Schaltverhalten des Passiviergasventils 28 bestimmt, was die Prozesseinstellung erleichtert.

In einer vierten Verfahrensvariante werden ausgehend von einer der erläuterten Verfahrensvarianten mindestens einer der Parameter Ätzschrittdauer t₂, Tankladezeit t_{L}, Ätzgasfluss, Passiviergasfluss oder eine über die Substratelektrode 20 in das Substrat 20 eingekoppelte Substratbiasleistung als Funktion der Zeit so variiert, dass der Prozess zunächst mit einem hohen Anteil an Passivierung startet und während des Prozesses die Menge an deponiertem Polymer kontinuierlich oder in diskreten Schritten abnimmt.

Obwohl die erläuterten Verfahren an sich unabhängig von den Details einer bestimmten Plasmaquelle 19 sind, so sind doch bestimmte Randbedingungen zu berücksichtigen. So hat ein Gaspulsbetrieb, bei dem schlagartig eine erhebliche Stoffmenge eines Gases im Austausch mit einem anderen Gas in die Plasmaquelle 19 strömt, darin einen sprunghaften Druckanstieg und veränderte Plasmabedingungen, auch hinsichtlich der Gassorte und deren Elektronegativität, zur Folge.

Für ein Verfahren gemäß DE 42 41 045 Cl ist es andererseits wichtig, dass das Plasma 22 stets stabil bleibt und über die zweite Impedanzanpasseinrichtung 16 stets gut "gematcht" ist, d.h. möglichst nicht ausgeht oder blinkt. Dies erfordert eine Plasmaquelle 19, die tolerant ist gegenüber Prozessschwankungen. Insofern wird bevorzugt eine insbesondere induktiv gekoppelte Plasmaquelle 19 mit hoher eingekoppelter Hochfrequenzleistung von 3000 Watt bis 5500 Watt und eine Ätzkammer mit einem möglichst kleinen Innendurchmesser von lediglich 5 cm bis 20 cm, insbesondere 9 cm bis 15 cm, eingesetzt. Die Leistung pro Fläche im Bereich der Plasmaquelle 19 oder am Ort des Substrates 21 wird auf diese Weise um mehr als eine Größenordnung auf Werte von mehr als 5 Watt/cm², insbesondere 20 Watt/cm² bis 30 Watt/cm², gesteigert. Ein derartiges Plasma 22 ist besonders tolerant gegenüber Prozessparameterschwankungen.

Um die Uniformität der Ätzergebnisse über Oberfläche des Substrates 21 dabei trotz der verkleinerten Ätzkammer 12 nicht zu beeinträchtigen, ist es sehr vorteilhaft, den in DE 100 51 831 A1 beschriebenen magnetischen Ionendiskriminator in Kombination mit einer Driftzone bei der Plasmaanlage 5 einzusetzen. Dadurch kommt es einerseits zu einer Homogenisierung der Verteilung der neutralen Radikale aus dem Plasma 22 auf ihrem Weg von der Plasmaquelle 19 hin zum Substrat 21, während der magnetische Ionendiskriminator für eine Homogenisierung bzw. Fokussierung des Ionenstromes zu dem Substrat 21 und eine Reflexion von Elektronen sorgt. Überdies treten die über die untere Spule 13 und die obere Spule 14 erzeugten Magnetfelder auch in die Plasmaquelle 19 selbst über und bewirken dort eine gesteigerte Elektronendichte in dem Plasma 22, das entsprechend robuster und toleranter gegenüber sprunghaften Änderungen wesentlicher Gasparameter wie Druck, Gasfluss, Gassorte und Elektronegativität wird.

Alternativ zu den vorstehend erläuterten Verfahrensvarianten wurde schließlich auch der Einsatz von Ventilen erprobt, die die Zufuhr von Ätzgas und Passiviergas alternierend zwischen der Ätzkammer 12 und einer in Figur 1 nicht dargestellten Bypassleitung zu einer Vorvakuumpumpe umschalten. Dies ermöglicht zwar ebenfalls die gewünschten kürzeren Taktzeiten, da dann nicht mehr die Regelgeschwindigkeit der Massenflussregler 29, 30 sondern die Schließzeiten der Ventile für die Taktzeiten entscheidend sind. Dieses Vorgehen hat aber den Nachteil, dass ein erheblicher Anteil der teueren Prozessgase ungenutzt verloren geht und als Abgas abgeführt werden muss. Dies gilt insbesondere für das Passiviergas, das ja nur für möglichst kurze Zeit, dafür aber vorteilhaft mit entsprechend großem Gasfluss der Ätzkammer 12 zugeführt werden soll, und das während der übrigen Zeit, d.h. der Ätzschrittdauer bzw. während des nachfolgenden Ätzgastaktes ungenutzt über die Bypassleitung abströmt. Dieses Vorgehen ist somit zwar möglich, jedoch vergleichsweise unwirtschaftlich.

## Patentansprüche

1. Verfahren zum anisotropen Einätzen von Strukturen in ein in einer Ätzkammer (12) angeordnetes Substrat (21), insbesondere von mit einer Ätzmaske definierten Strukturen in ein Siliziumsubstrat, mittels eines Plasmas (22), wobei zumindest zeitweilig ein Ätzgas und zumindest zeitweilig ein Passiviergas eingesetzt wird, wobei das Passiviergas und das Ätzgas der Ätzkammer (12) getaktet zugeführt wird, wobei die Passiviergastakte eine zeitliche Länge zwischen 0,05 s und 1 s aufweisen, **dadurch gekennzeichnet, dass** die Dauer der Passivierschritte um einen Faktor 10 bis 30 kürzer als die Dauer der Ätzschritte eingestellt wird.

2. Verfahren nach Anspruch 1, **dadurch gekennzeichnet, dass** jeder der Passiviergastakte eine insbesondere gleiche zeitliche Länge zwischen 0,1 s bis 0,5 s aufweist.

3. Verfahren nach Anspruch 1 oder 2, **dadurch gekennzeichnet, dass** jeder Ätzgastakt eine zeitliche Länge zwischen 1 s und 15s, insbesondere 2 s bis 7 s, aufweist.

4. Verfahren nach einem der vorangehenden Ansprüche, **dadurch gekennzeichnet, dass** das Ätzgas und das Passiviergas alternierend während separater, unabhängig voneinander gesteuerter Ätzschritte und Passvierschritte eingesetzt werden, wobei das Passiviergas der Ätzkammer (12) zumindest weitgehend lediglich während der Passivierschritte und das Ätzgas, insbesondere SF₆, der Ätzkammer (12) zumindest weitgehend lediglich während der Ätzschritte zugeführt wird.

5. Verfahren nach einem der vorangehenden Ansprüche, **dadurch gekennzeiehnet,** dass als Passiviergas ein Gas ausgewählt aus der Gruppe C₄F₈, C₃F₆ C₄F₆, C₅F₈ oder C₂H₂F₂ oder eine Gasmischung mit mindestens einem dieser Gase eingesetzt wird.

6. Verfahren nach einem der vorangehenden Ansprüche, **dadurch gekennzeichnet, dass** das anisotrope Einätzen in separaten, alternierend aufeinander folgenden Ätzschritten und Passivierschritten erfolgt, wobei mit Hilfe des Passiviergases während der Passivierschritte auf die durch die Ätzmaske definierte laterale Begrenzung der Strukturen ein insbesondere teflonartiges Polymer aufgebracht wird, das während des nachfolgenden Ätzschrittes zumindest teilweise wieder abgetragen und in tieferen Regionen der erzeugten Struktur redeponiert wird.

7. Verfahren nach einem der vorangehenden Ansprüche, **dadurch gekennzeichnet, dass** ein hochdichtes Plasma (22) mit mindestens 10¹² reaktiven Spezies/cm³ erzeugt wird, und dass zumindest zeitweilig während der Ätzschritte ein insbesondere gepulster lonenbeschuss des Substrates (21), insbesondere mit einer Ionenenergie von 1 eV bis 100 eV im Dauerstrichbetrieb oder im zeitlichen Mittel, erfolgt.

8. Verfahren nach einem der vorangehenden Ansprüche, **dadurch gekennzeichnet, dass** die während der einzelnen Passivierschritte jeweils eingesetzte Menge an Passiviergas mit einem Fortschreiten des Einätzens kontinuierlich oder schrittweise reduziert wird.

9. Plasmaanlage zum anisotropen Einätzen von Strukturen in ein Substrat (21), insbesondere von mit einer Ätztnaske definierten Strukturen in ein Siliziumsubstrat, mit einer Ätzkammer (12), in der bei Betrieb der Plasmaanlage (5) das Substrat (21) insbesondere auf einer Substratelektrode (20) angeordnet ist, einer Plasmaquelle (19), mit der ein auf das Substrat (21) einwirkendes Plasma (22) erzeugbar ist, und Mitteln (17, 23, 24, 25, 26,27,28,29, 30) zur zumindest zeitweiligen Zufuhr eines Ätzgases und zur zumindest zeitweiligen Zufuhr eines Passiviergases zu der Ätzkammer (12), wobei die Mitteln eine Passiviergasleitung (25) und eine davon verschiedene Ätzgasteitung (26) umfassen, **dadurch gekennzeichnet, dass** die Passiviergasleitung (25) mit einem zwischengeschalteten Puffertank (24) und einem diesem nachgeordneten schnell schaltenden Passiviergasventil (28) versehen ist.

10. Plasmaanlage nach Anspruch 9, **dadurch gekennzeichnet, dass** die Mittel (17, 23,24,25,26,27,28,29, 30) derart ausgebildet und eine Pumpeinrichtung (31) zum Evakuieren der Ätzkammer (12) derart vorgesehen ist, dass das Ätzgas und das Passiviergas alternierend während separater, unabhängig voneinander gesteuerter Ätzschritte und Passvierschritte der Ätzkammer (12) zugeführt werden, und dass die Ätzkammer (12) während der Ätzschritte zumindest in dem Bereich, in dem die Plasmaquelle (19) auf das Ätzgas einwirkt, zumindest näherungsweise frei von dem Passiviergas und die Ätzkammer (12) während der PassiviErschritte zumindest in dem Bereich, in dem die Plasmaquelle (19) auf das Passiviergas einwirkt, zumindest näherungsweise frei von dem Ätzgas ist.

11. Plasmaanlage nach einem der Ansprüche 9 oder 10, **dadurch gekennzeichnet, dass** die Passiviergasleitung (25) und die davon verschiedene Ätzgasleitung (26) jeweils direkt in die Ätzkammer (12) münden, oder dass eine Passiviergasleitung (25) und eine davon verschiedene Ätzgasleitung (26) vorgesehen sind, die unmittelbar, insbesondere in einem Abstand von weniger als 20 cm, vor der Ätzkammer (12) in eine Zufuhrleitung (23) münden, die zu der Ätzkammer (12) führt.

12. Plasmaanlage nach einem der Ansprüche 9 bis 11, **dadurch gekennzeichnet, dass** die Ätzgasleitung (26) mit einem Ätzgasventil (27) versehen ist, mit dem der Zufuhr von Ätzgas zu der Ätzkammer (12) insbesondere unmittelbar vor einer Zufuhr von Passiviergas zu der Ätzkammer (12) unterbrechbar ist.

13. Plasmaanlage nach einem der Ansprüche 9 bis 12, **dadurch gekennzeichnet, dass** das Ätzgasventil (27) und/oder das Passiviergasventil (28) unmittelbar, insbesondere in einem Abstand von weniger als 20 cm, vor der Mündung der Ätzgasleitung (26) und/oder der Passiviergasleitung (25) in die Ätzkammer (12) oder die Zufuhrleitung (23) angeordnet ist.

14. Plasmaanlage nach einem der Ansprüche 9 bis 13, **dadurch gekennzeichnet, dass** das Ätzgasventil (27) und das Passiviergasventil (28) in einem Umschaltventil zusammengefasst sind, über das wahlweise die Ätzgasleitung (26) oder die Passiviergasleitung (25) gasdurchgängig mit der Ätzkammer (12) verbindbar ist.

15. Plasmaanlage nach Anspruch 9, **dadurch gekennzeichnet, dass** der Puffertank ein Volumen von 0,1 Liter bis 1 Liter aufweist.

16. Plasmaanlage nach einem der Ansprüche 9 bis 15, **dadurch gekennzeichnet, dass** das eine insbesondere induktiv gekoppelte Plasmaquelle (19) vorgesehen ist und die Ätzkammer (12) zumindest in dem Bereich der Plasmaquelle (19) einen Innendurchmesser von 5 cm bis 20 cm aufweist, so dass bei Betrieb der Plasmaanlage (5) und Speisung der Plasmaquelle (19) über einen Hochspannungsgenerator (15) im Inneren der Ätzkammer (12) in dem Bereich der Plasmaquelle (19) oder am Ort des Substrates (21) eine Leistung pro Fläche von mehr als 5 Watt/cm², insbesondere mehr als 15 Watt/cm², erreichbar ist.

17. Plasmaanlage nach einem der Ansprüche 9 bis 16, **dadurch gekennzeichnet, dass** zwischen der PlasmaqueHe (19) und dem Substrat (21) mindestens eine die Ätzkammer (12) umgebende Spule (13, 14), insbesondere mindestens zwei, die Ätzkammer (12) äußerlich umgebende, bei Betrieb paarweise gegensinnig von einem Strom durchflossene, untereinander angeordnete Spulen (13, 14), vorgesehen sind.

18. Plasmaanlage nach einem der Ansprüche,9-17 **dadurch gekennzeichnet, dass** damit ein Verfahren nach einem der Ansprüche 1 bis 8 durchführbar ist.

## Claims

1. Method for anisotropically etching structures into a substrate (21) arranged in an etching chamber (12), in particular structures defined by means of an etching mask into a silicon substrate, by means of a plasma (22), an etching gas being used at least temporarily and a passivating gas being used at least temporarily, the passivating gas and the etching gas being fed to the etching chamber (12) cyclically, the passivating gas cycles having a temporal length of between 0.05 s and 1 s, **characterized in that** the duration of the passivating steps is set such that it is a factor of 10 to 30 shorter than the duration of the etching steps.

2. Method according to Claim 1, **characterized in that** each of the passivating gas cycles has an, in particular identical, temporal length of between 0.1 s and 0.5 s.

3. Method according to Claim 1 or 2, **characterized in that** each etching gas cycle has a temporal length of between 1 s and 15 s, in particular 2 s to 7 s.

4. Method according to one of the preceding claims, **characterized in that** the etching gas and the passivating gas are used alternately during separate etching steps and passivating steps that are controlled independently of one another, the passivating gas being fed to the etching chamber (12) at least largely only during the passivating steps and the etching gas, in particular SF₆, being fed to the etching chamber (12) at least largely only during the etching steps.

5. Method according to one of the preceding claims, **characterized in that** a gas selected from the group C₄F₈, C₃F₆, C₄F₆, C₅F₈ or C₂H₂F₂ or a gas mixture comprising at least one of these gases is used as the passivating gas.

6. Method according to one of the preceding claims, **characterized in that** the anisotropic etching-in is effected in separate etching steps and passivating steps that alternately succeed one another, and in particular Teflon-like polymer being applied with the aid of the passivating gas during the passivating steps onto the lateral boundary of the structures that is defined by the etching mask, which polymer, during the subsequent etching step, is at least partly removed again and redeposited in deeper regions of the structure produced.

7. Method according to one of the preceding claims, **characterized in that** a high density plasma (22) with at least 10¹² reactive species/cm³ is produced, and **in that** an in particular pulsed ion bombardment of the substrate (21), in particular with an ion energy of 1 eV to 100 eV in continuous wave operation or on average over time, is effected at least temporarily during the etching steps.

8. Method according to one of the preceding claims, **characterized in that** the quantity of passivating gas that is respectively used during the individual passivating steps is reduced continuously or stepwise as the etching-in progresses.

9. Plasma system for anisotropically etching structures into a substrate (21), in particular structures defined by means of an etching mask into a silicon substrate, having an etching chamber (12), in which the substrate (21) is arranged in particular on a substrate electrode (20) during operation of the plasma system (5), a plasma source (19), which can generate a plasma (22) acting on the substrate (21), and means (17, 23, 24, 25, 26, 27, 28, 29, 30) for at least temporarily feeding in an etching gas and for at least temporarily feeding in a passivating gas to the etching chamber (12), the means comprising a passivating gas line (25) and an etching gas line (26) different from the latter, **characterized in that** the passivating gas line (25) is provided with an interposed buffer tank (24) and a rapidly switching passivating gas valve (28) disposed downstream of the latter.

10. Plasma system according to Claim 9, **characterized in that** the means (17, 23, 24, 25, 26, 27, 28, 29, 30) are formed in such a way, and a pump device (31) for evacuating the etching chamber (12) is provided in such a way, that the etching gas and the passivating gas are fed to the etching chamber (12) alternately during separate etching steps and passivating steps that are controlled independently of one another, and that the etching chamber (12) is at least approximately free of the passivating gas during the etching steps at least in the region in which the plasma source (19) acts on the etching gas, and the etching chamber (12) is at least approximately free of the etching gas during the passivating steps at least in the region in which the plasma source (19) acts on the passivating gas.

11. Plasma system according to either of Claims 9 and 10, **characterized in that** the passivating gas line (25) and the etching gas line (26) different from the latter in each case open directly into the etching chamber (12), or **in that** a passivating gas line (25) and an etching gas line (26) different from the latter are provided which open into a feed line (23) directly, in particular at a distance of less than 20 cm, before the etching chamber (12), said feed line leading to the etching chamber (12).

12. Plasma systems according to one of Claims 9 to 11, **characterized in that** the etching gas line (26) is provided with an etching gas valve (27), which can interrupt the feeding of etching gas to the etching chamber (12) in particular directly before a feeding of passivating gas to the etching chamber (12).

13. Plasma system according to one of Claims 9 to 12, **characterized in that** the etching gas valve (27) and/or the passivating gas valve (28) are/is arranged directly, in particular at a distance of less than 20 cm, before the opening of the etching gas line (26) and/or the passivating gas line (25) into the etching chamber (12) or the feed line (23).

14. Plasma system according to one of Claims 9 to 13, **characterized in that** the etching gas valve (27) and the passivating gas valve (28) are combined in a changeover valve via which optionally the etching gas line (26) or the passivating gas line (25) can be connected to the etching chamber (12) in a manner exhibiting continuous passage of gas.

15. Plasma system according to Claim 9, **characterized in that** the buffer tank has a volume of 0.1 litre to 1 litre.

16. Plasma system according to one of Claims 9 to 15, **characterized in that** an in particular inductively coupled plasma source (19) is provided and the etching chamber (12) has an internal diameter of 5 cm to 20 cm at least in the region of the plasma source (19), so that, during operation of the plasma system (5) and with the plasma source (19) being supplied via a high-voltage generator (15), in the interior of the etching chamber (12) in the region of the plasma source (19) or at the location of the substrate (21), it is possible to achieve a power per area of more than 5 watts/cm², in particular more than 15 watts/cm².

17. Plasma system according to one of Claims 9 to 16, **characterized in that**, between the plasma source (19) and the substrate (21), provision is made of at least one coil (13, 14) surrounding the etching chamber (12), in particular at least two coils (13, 14) which externally surround the etching chamber (12), are arranged one under the other and have a current flowing through them in opposite senses in pairs during operation.

18. Plasma system according to one of Claims 9-17, **characterized in that** it can be used to carry out a method according to one of Claims 1 to 8.

## Revendications

1. Procédé de gravure anisotrope de structures dans un substrat (21) placé dans une chambre de gravure (12), en particulier de structures définies par un masque de gravure dans un substrat de silicium, au moyen d'un plasma (22), en utilisant au moins momentanément un gaz de gravure et un gaz de passivation injectés de manière cyclique dans la chambre de gravure (12), les cycles de gaz de passivation possédant une durée de 0,05 s à 1 s,
**caractérisé en ce que**
la durée des étapes de passivation est plus courte d'un facteur 10 à 30 que la durée des étapes de gravure.

2. Procédé selon la revendication 1,
**caractérisé en ce que**
chacun des cycles de gaz de passivation possède en particulier une durée identique de 0,1 s à 0,5 s.

3. Procédé selon la revendication 1, ou 2,
**caractérisé en ce que**
chacun des cycles de gaz de gravure possède une durée de 1 s à 15 s, en particulier de 2 s à 7 s.

4. Procédé selon l'une des revendications précédentes,
**caractérisé en ce qu'**
on utilise en alternance le gaz de gravure et le gaz de passivation au cours d'étapes de gravure et d'étapes de passivation séparées contrôlées indépendamment les unes des autres, le gaz de passivation étant injecté dans la chambre de gravure (12) au moins dans une large mesure seulement pendant les étapes de passivation et le gaz de gravure, en particulier du SF₆, étant injecté dans la chambre de gravure (12) au moins dans une large mesure seulement pendant les étapes de gravure.

5. Procédé selon une des revendications précédentes,
**caractérisé en ce que**
comme gaz de passivation on utilise un gaz choisi dans le groupe du C₄F₈, du C₃F₆, du C₄F₆, du C₅F₈ et du C₂H₂F₂ ou un mélange contenant au moins un de ces gaz.

6. Procédé selon l'une des revendications précédentes,
**caractérisé en ce que**
la gravure anisotrope a lieu dans des étapes de gravure et de passivation séparées se succédant en alternance, et à l'aide du gaz de passivation, pendant les étapes de passivation, sur la limite latérale des structures définie par le masque de gravure on applique un polymère en particulier de type Téflon, qui est au moins partiellement éliminé pendant l'étape de gravure suivante et redéposé dans des régions plus profondes de la structure créée.

7. Procédé selon l'une des revendications précédentes,
**caractérisé en ce qu'**
on produit un plasma à haute densité (22) possédant au moins 10¹² espèces réactives/cm³, et au moins momentanément pendant les étapes de gravure a lieu un bombardement ionique en particulier pulsé du substrat (21), notamment avec une énergie ionique de 1 eV à 100 eV en mode continu ou en moyenne temporelle.

8. Procédé selon l'une des revendications précédentes,
**caractérisé en ce que**
la quantité de gaz de passivation utilisée pendant les différentes étapes de passivation est réduite en continu ou par paliers lors de la poursuite de la gravure.

9. Installation au plasma de gravure anisotrope de structures dans un substrat (21), en particulier de structures définies par un masque de gravure dans un substrat de silicium, comprenant une chambre de gravure (12) dans laquelle, lors du fonctionnement de l'installation au plasma (5), le substrat (21) est placé en particulier sur une électrode de substrat (20), une source de plasma (19) avec laquelle un plasma (22) agissant sur le substrat (21) peut être créé, et des moyens (17, 23, 24, 25, 26, 27, 28, 29, 30) pour injecter au moins momentanément un gaz de gravure et injecter au moins momentanément un gaz de passivation dans la chambre de gravure (12), les moyens comprenant une conduite de gaz de passivation (25) et une conduite de gaz de gravure (26) différente de celle-ci,
**caractérisée en ce que**
la conduite de gaz de passivation (25) est dotée d'un réservoir intermédiaire intercalé (24) et d'une soupape de gaz de passivation (28) à action rapide montée en aval de celui-ci.

10. Installation au plasma selon la revendication 9,
**caractérisée en ce que**
les moyens (17, 23, 24, 25, 26, 27, 28, 29, 30) et un équipement de pompe (31) pour évacuer la chambre de gravure (12) sont configurés pour injecter le gaz de gravure et le gaz de passivation dans la chambre de gravure (12) alternativement au cours d'étapes de gravure et d'étapes de passivation contrôlées indépendamment les unes des autres, et la chambre de gravure (12) est au moins approximativement vide de gaz de passivation pendant les étapes de gravure, au moins dans la région dans laquelle la source de plasma (19) agit sur le gaz de gravure, et la chambre de gravure (12) est au moins approximativement vide de gaz de gravure pendant les étapes de passivation, au moins dans la région dans laquelle la source de plasma (19) agit sur le gaz de passivation.

11. Installation au plasma selon l'une des revendications 9 ou 10,
**caractérisée en ce que**
la conduite de gaz de passivation (25) et la conduite de gaz de gravure (26) différente de celle-ci débouchent chacune directement dans la chambre de gravure (12), ou il est prévu une conduite de gaz de passivation (25) et une conduite de gaz de gravure (26) différente de celle-ci qui débouchent immédiatement, en particulier à une distance de moins de 20 cm, en amont de la chambre de gravure (12), dans une conduite d'alimentation (23) conduisant à la chambre de gravure (12).

12. Installation au plasma selon l'une des revendications 9 à 11,
**caractérisée en ce que**
la conduite de gaz de gravure (26) est dotée d'une soupape de gaz de gravure (27) pour interrompre l'injection de gaz de gravure dans la chambre de gravure (12) en particulier immédiatement avant une injection de gaz de passivation dans la chambre de gravure (12).

13. Installation au plasma selon l'une des revendications 9 à 12,
**caractérisée en ce que**
la soupape de gaz de gravure (27) et/ou la soupape de gaz de passivation (28) sont immédiatement, en particulier à une distance de moins de 20 cm, en amont de la sortie de la conduite de gaz de gravure (26) et/ ou de la conduite de gaz de passivation (25) dans la chambre de gravure (12) ou la conduite d'alimentation (23).

14. Installation au plasma selon l'une des revendications 9 à 13,
**caractérisée en ce que**
la soupape de gaz de gravure (27) et la soupape de gaz de passivation (28) sont réunies dans une soupape d'inversion reliant au choix la conduite de gaz de gravure (26) ou la conduite de gaz de passivation (25) en connexion gazeuse avec la chambre de gravure (12).

15. Installation au plasma selon la revendication 9,
**caractérisée en ce que**
le réservoir intermédiaire possède un volume de 0,1 litre à 1 litre.

16. Installation au plasma selon l'une des revendications 9 à 15,
**caractérisée en ce qu'**
une source de plasma (19) est couplée en particulier de manière inductive et la chambre de gravure (12) possède un diamètre intérieur de 5 cm à 20 cm au moins dans la région de la source de plasma, de façon à pouvoir atteindre, lors du fonctionnement de l'installation au plasma (5) et de l'injection de la source de plasma (19) par un générateur à haute tension (15) à l'intérieur de la chambre de gravure (12) dans la région de la source de plasma (19) ou à l'emplacement du substrat (21), une puissance par unité de surface de plus de 5 watts/cm², en particulier de plus de 15 watts/cm².

17. Installation au plasma selon l'une des revendications 9 à 16,
**caractérisée en ce qu'**
entre la source de plasma (19) et le substrat (21) au moins une bobine (13, 14) entourant la chambre de gravure (12), en particulier au moins deux bobines (13, 14) l'une derrière l'autre, entourant extérieurement la chambre de gravure (12), sont parcourues en mode de fonctionnement par un courant en sens inverse par paire.

18. Installation au plasma selon l'une des revendications 9 à 17,
**caractérisée en ce qu'**
elle applique un procédé selon l'une des revendications 1 à 8.
